# FASCICULE DE BREVET EUROPEEN

(11) **EP 1 168 618 B1**
(45) Date de publication et mention de la délivrance du brevet: **15.10.2008**
(21) Numéro de dépôt: 01401700.8
(22) Date de dépôt: 27.06.2001
(51) Int. Cl.: H03K 3/84

(54) **Dispositif à circuit(s) logique(s) pour la génération d'un signal aléatoire**
Logische Schaltungsvorrichtung zum Erzeugen eines Zufallssignals
Logic circuit device for generating a random signal

(30) Priorité: 27.06.2000 FR 0008241
(43) Date de publication de la demande: 02.01.2002
(73) Titulaire: Etat Français représenté par le Délégué Général pour l'Armement, 94114 Arcueil Cedex (FR)
(72) Inventeur: Hourdequin, Marc, 35890 Luille (FR); Lagorce, Christian, 35320 Pance (FR); Malaquin, Laurent, 35310 Chavagne (FR)

(56) Documents cités:
- US-A- 5 961 577
- PETRIE C S ET AL: "MODELING AND SIMULATION OF OSCILLATOR-BASED RANDOM NUMBER GENERATORS" IEEE INTERNATIONAL SYMPOSIUM ON CIRCUITS AND SYSTEMS (ISCAS),US,NEW YORK, IEEE, 12 mai 1996 (1996-05-12), pages 324-327, XP000704602 ISBN: 0-7803-3074-9
- CASTANIE F: "GENERATION OF RANDOM BITS WITH ACCURATE AND REPRODUCIBLE STATISTICAL PROPERTIES" PROCEEDINGS OF THE IEEE,US,IEEE. NEW YORK, vol. 66, no. 7, 1 juillet 1978 (1978-07-01), pages 807-809, XP002022447 ISSN: 0018-9219

## Description

La présente invention est relative aux dispositifs pour la génération de signaux aléatoires.

Elle trouve avantageusement, mais non limitativement, application aux dispositifs pour la génération de signaux aléatoires du type à circuit(s) logique(s).

Un but général de l'invention est de proposer un dispositif permettant la génération de signaux aléatoires de qualité.

On connaît déjà de nombreux dispositifs à circuits logiques présentés comme permettant la génération de signaux aléatoires (combinaison d'horloges asynchrones, utilisation du positionnement à la mise sous tension d'un plan mémoire). Le caractère aléatoire de tels dispositifs peut-être pris en défaut sous certaines conditions, ce qui les rend impropres pour de nombreuses applications où la qualité de l'aléa est primordiale tel que le chiffrement des données.

Lorsqu'un aléa de qualité est désiré, les concepteurs de circuits électroniques ont habituellement recours à des systèmes analogiques (tel que l'amplification d'un bruit de fond). Ces solutions ne sont pas intégrables dans des circuits logiques et notamment dans des ASICs ou FPGAs. Il en résulte une perte d'intégration, puisqu'il est nécessaire d'utiliser un dispositif spécifique afin de réaliser la fonction requise.

Un autre but de l'invention est de proposer une solution apte à être réalisée avec des circuits logiques.

On sait que les bruits électroniques sont classés en deux catégories principales : le bruit thermique et le bruit de grenaille (également souvent désigné par "popcorn noise", ou "bruit popcorn", par l'homme du métier pour décrire les instabilités du niveau moyen d'un signal à variation rapide).

L'invention propose quant à elle de tirer partie des bruits d'origine thermique et de leur combinaison avec les bruits de jonction des semi-conducteurs.

Elle propose en particulier un dispositif pour la génération d'un signal aléatoire, caractérisé en ce qu'il comprend un circuit électronique à état transitoire, ainsi que des moyens aptes à commander l'activité et/ou l'arrêt dudit circuit, afin de générer un signal aléatoire sur la sortie de celui-ci.

Un tel circuit à état transitoire, selon qu'il est en activité ou que son activité est arrêtée, s'échauffe ou se refroidit. Son échauffement génère en sortie un signal aléatoire.

Le circuit comporte avantageusement, mais non limitativement, des moyens logiques à semi-conducteur(s).

Notamment, dans un mode de réalisation préféré, le dispositif comporte un circuit oscillateur à moyens de type semi-conducteur(s) et des moyens aptes à commander l'activité et/ou l'arrêt dudit circuit.

Avec un tel oscillateur, le bruit d'origine thermique et le bruit de jonction des semiconducteurs s'amplifient l'un, l'autre pendant une phase d'échauffement, notamment au démarrage du dispositif. La vitesse des porteurs aux jonctions dépend de la température ; celle-ci augmente lors des opérations de transfert des porteurs. Il y a une « auto - amplification » de l'instabilité jusqu'à stabilisation thermique du dispositif (c'est-à-dire la chaleur produite est égale à la chaleur évacuée). Le phénomène d'instabilité n'existe ainsi que durant une période très courte (durée nécessaire pour que la jonction passe de la température ambiante à une température stable). Cette durée varie de la centaine de micro-seconde à au plus la milli-seconde pour les circuits expérimentés (en particulier des circuits CMOS en 0,8 micron). Ce paramètre est propre à une technologie donnée.

Avantageusement encore, la sortie du circuit oscillateur est bouclée sur l'entrée de celui-ci.

Le bouclage du circuit sur lui-même auto amplifie les phénomènes d'instabilité sur la sortie non contrôlée du circuit. Le circuit utilise ainsi sa propre instabilité afin de l'amplifier (et de l'entretenir le plus longtemps possible).

Dans un mode de réalisation préféré, le circuit oscillateur comporte des moyens formant inverseur qui inversent sur sa sortie le signal présent à son entrée, ainsi qu'une boucle entre son entrée et sa sortie.

Notamment, des moyens aptes à commander le fonctionnement ou l'arrêt du circuit oscillateur peuvent comporter des moyens formant interrupteurs disposés dans la boucle entre la sortie des moyens formant inverseur et la sortie du circuit oscillateur.

Les moyens formant inverseurs peuvent comporter une pluralité d'inverseurs en nombre impair.

Par ailleurs, le phénomène utilisé ayant un caractère éphémère, on couple, afin d'obtenir un flux continu, au moins deux dispositifs, l'un fournissant l'instabilité pendant que l'autre refroidi.

Ainsi, l'invention a également pour objet un dispositif à circuit(s) logique(s) pour la génération d'un signal aléatoire, caractérisé en ce que pour générer ledit signal aléatoire de façon continue, il comporte plusieurs dispositifs, des moyens pour commander successivement de façon alternée l'activité, puis l'arrêt des circuits à état transitoire de chacun des dispositifs, ainsi que des moyens pour combiner les sorties des différents dispositifs.

Avantageusement, les moyens de combinaison mettent en oeuvre sur les sorties des différents dispositifs une combinaison de type OU EXCLUSIF.

De préférence, les moyens de commande comportent au moins un compteur qui reçoit en entrée le signal en sortie de moyens combinant les sorties des différents dispositifs, ainsi que des moyens pour commander l'activité et/ou l'arrêt des moyens de type à semi-conducteur(s) desdits dispositifs en fonction du décompte dudit compteur.

Comme on l'aura compris, les dispositifs proposés par l'invention sont avantageusement intégrés dans un circuit intégré spécifique ou dans un circuit intégré programmable (ASIC ou FPGA).

D'autres caractéristiques et avantages de l'invention ressortiront encore de la description qui suit, laquelle est purement illustrative et non limitative et doit être lue en regard des dessins annexés sur lesquels :
- la figure 1 est un schéma de principe d'un dispositif à circuit logique conforme à un mode de réalisation possible de l'invention ;
- la figure 2 est un schéma d'un dispositif à flux continu conforme à un mode de réalisation possible de l'invention ;
- la figure 3 est un schéma d'un dispositif analogique illustrant un autre mode de réalisation possible de l'invention.

Le circuit 11 qui illustre un exemple de réalisation possible de l'invention comprend un inverseur 111 - ou une série d'inverseurs en nombre impair - bouclé sur lui-même à travers une porte logique 112.

Cette porte, qui constitue un moyen formant interrupteur qui autorise ou non le re-bouclage du signal, est commandée par un signal externe 12.

Tant que le circuit 11 n'est pas stabilisé thermiquement, sa sortie 13 présente un caractère aléatoire (en fréquence essentiellement) lorsque la commande 12 autorise le bouclage. Ce caractère aléatoire est fortement présent et exploitable jusqu'à la stabilisation thermique du circuit.

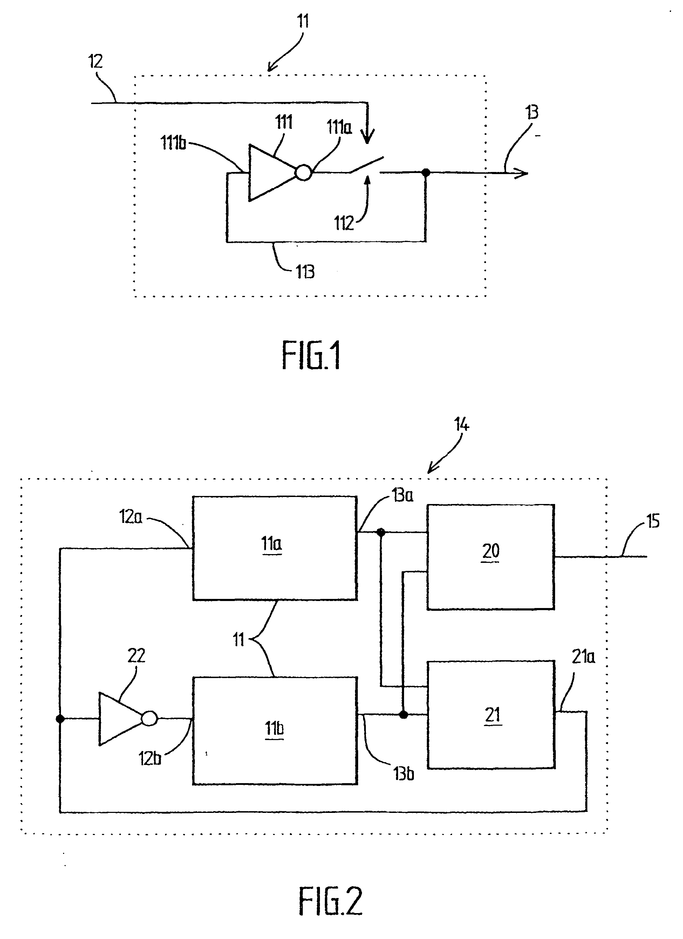

Le mode de réalisation illustré sur la figure 2 permet quant à lui de générer un signal aléatoire sans discontinuité.

Le dispositif, référencé par 14, qui est représenté sur cette figure 2, comporte plusieurs circuits du type du circuit de la figure 1, en l'occurrence deux, référencés par 11a et 11b. Le nombre de circuits est ici réduit pour la simplification de l'exposé, mais peut être bien entendu plus important. Notamment, les inventeurs ont testé des dispositifs comportant jusqu'à cinq circuits du type de celui de la figure 1.

Les moyens qui commandent les circuits 11a, 11b sont tels qu'un seul de ces circuits n'est exploité à la fois.

Les sorties 13a, 13b sont combinées dans des moyens 20 pour générer un seul signal de sortie (sortie 15).

Les moyens 20 qui assurent la combinaison des sorties 13a, 13b sont constitués par un circuit XOR (OU EXCLUSIF), ce qui permet de s'affranchir de l'état 1 ou 0 du circuit stable.

Egalement, une sortie combinée alimente un compteur 21 qui réalise un décompte suivant un module choisi. Ce modulo est choisi aussi grand que possible, sans néanmoins être trop important afin que le temps de comptage pour l'atteindre soit toujours inférieur au temps de stabilisation thermique.

En l'occurrence, sur le schéma de la figure 2, le dispositif 21 intègre à la fois des moyens de comptage et un circuit XOR de combinaison en amont de ces moyens.

La sortie 21a de bit de poids fort du compteur 21 est utilisée pour commander les portes logiques des circuits 11a, 11b. Ce bit 21a est envoyé directement à l'un des circuits et est inversé avant d'être envoyé sur l'autre. En l'occurrence, le signal 21a constitue directement le signal 12a qui commande le circuit 11a. Il est inversé à travers un inverseur 22 pour constituer le signal 12b qui constitue le circuit 11b.

L'invention a été ici décrite dans le cas d'un circuit spécifique à oscillateur logique, mais s'applique de façon plus générale à tout dispositif comportant des moyens à semi-conducteur(s) et de façon encore plus générale à tout dispositif comportant un circuit électronique à état transitoire. De tels moyens présentent en effet lors d'un échauffement ou d'un refroidissement (par lui-même ou par un autre moyen, par exemple des circuits proches) une instabilité, laquelle se manifeste par une variation aléatoire de la vitesse de combinaisons-recombinaisons des porteurs ce qui influence de nombreux paramètres : temps de propagation, temps de montée et de descente des signaux, fan-out etc. Et cette activité de combinaisons-recombinaisons produit de la chaleur.

Notamment, l'invention peut également trouver application avec des structures à circuits analogiques.

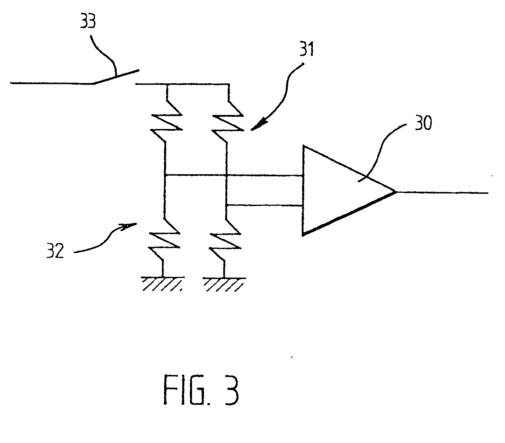

Une structure en ce sens est illustrée sur la figure 3, sur laquelle on a représenté un circuit analogique qui comporte: un amplificateur différentiel 30 et deux ponts diviseurs de tension 31, 32 identiques dont les sorties sont injectées sur respectivement l'une et l'autre des deux entrées de l'amplificateur 30. L'alimentation de ces deux ponts diviseurs 31, 32 est commandée par un interrupteur 33.

Durant la phase d'échauffement des résistances des ponts diviseurs 31, 32, il existe une différence de tension entres les sorties des deux ponts diviseurs, qui est un signal aléatoire qu'il est possible d'exploiter grâce à l'amplificateur différentiel 30.

Les solutions à circuits logiques de type à semi-conducteur(s) sont néanmoins préférés.

Le dispositif est alors avantageusement intégré sur un circuit FPGA ou un ASIC. Les inventeurs ont notamment testé l'invention avec une réalisation sur un ACTEL 1010.

Dans le cas d'un ASIC, le ou les dispositifs de génération d'aléa sont avantageusement disposés dans des zones ayant des activités électriques les moins synchrones possibles.

## Revendications

1. Dispositif pour la génération d'un signal aléatoire, **caractérisé en ce qu'**il comprend un circuit électronique à état transitoire, ainsi que des moyens (112) aptes à commander l'activité et/ou l'arrêt dudit circuit, afin de générer un signal aléatoire sur la sortie de celui-ci.

2. Dispositif selon la revendication 1, **caractérisé en ce que** le circuit comporte des moyens logiques de type à semi-conducteur(s).

3. Dispositif selon la revendication 2, **caractérisé en ce qu'**il comporte un circuit oscillateur à moyens de type semi-conducteur et des moyens aptes à commander l'activité et/ou l'arrêt dudit circuit.

4. Dispositif selon la revendication 3, **caractérisé en ce que** la sortie du circuit oscillateur (11) est bouclée (113) sur l'entrée de celui-ci.

5. Dispositif selon la revendication 4, **caractérisé en ce que** le circuit oscillateur comporte des moyens formant inverseur (111) qui inversent sur sa sortie (111a) le signal présent à son entrée (111 b), ainsi qu'une boucle entre son entrée et sa sortie.

6. Dispositif selon la revendication 5, **caractérisé en ce que** des moyens aptes à commander l'activité ou l'arrêt du circuit oscillateur comportent des moyens (112) formant interrupteurs disposés dans la boucle entre la sortie des moyens formant inverseur et la sortie du circuit oscillateur.

7. Dispositif selon l'une des revendications 5 ou 6, **caractérisé en ce que** les moyens formant inverseurs comportent une pluralité d'inverseurs (111) en nombre impair.

8. Dispositif à circuit(s) logique(s) pour la génération d'un signal aléatoire, **caractérisé en ce que** pour générer ledit signal aléatoire de façon continue, il comporte plusieurs dispositifs (11a, 11b) selon l'une des revendications précédentes, des moyens (21, 22) pour commander successivement de façon alternée l'activité, puis l'arrêt des circuits à état transitoire de chacun des dispositifs, ainsi que des moyens (20) pour combiner les sorties des différents dispositifs.

9. Dispositif selon la revendication 8, **caractérisé en ce que** les moyens de combinaison mettent en oeuvre sur les sorties des différents dispositifs une combinaison de type OU EXCLUSIF.

10. Dispositif selon la revendication 9, **caractérisé en ce que** les moyens de commande comportent au moins un compteur (21) qui reçoit en entrée le signal en sortie de moyens combinant les sorties des différents dispositifs, ainsi que des moyens pour commander l'activité ou l'arrêt des moyens de type à semi-conducteur(s) desdits dispositifs en fonction du décompte dudit compteur.

11. Dispositif selon l'une des revendications précédentes, **caractérisé en ce qu'**il est intégré dans un circuit intégré spécifique ou dans un circuit intégré programmable.

## Claims

1. Device for generating a random signal, **characterized in that** it includes a transient state electronic circuit, and means (112) which are suitable for controlling the activity and/or the stopping of the said circuit, to generate a random signal at the output of the latter.

2. Device according to Claim 1, **characterized in that** the circuit includes logic means of the type with semiconductor(s).

3. Device according to Claim 2, **characterized in that** it includes an oscillator circuit with means of semiconductor type and suitable means for controlling the activity and/or the stopping of the said circuit.

4. Device according to Claim 3, **characterized in that** the output of the oscillator circuit (11) is looped to its input.

5. Device according to Claim 4, **characterized in that** the oscillator circuit includes means which form an inverter (111), said means inverting, at its output (111a), the signal which is present at its input (111b), and a loop between its input and its output.

6. Device according to Claim 5, **characterized in that** suitable means for controlling the activity or the stopping of the oscillator circuit includes means (112) which form switches, which are arranged in the loop between the output of the means forming the inverter and the output of the oscillator circuit.

7. Device according to one of Claims 5 or 6, **characterized in that** the means forming inverters include multiple inverters (111) in an odd number.

8. Device with logic circuit(s) for generating a random signal, **characterized in that**, to generate the said random signal in a continuous manner, it includes multiple devices (11a, 11b) according to one of the preceding claims, means (21, 22) for controlling, successively and in an alternating manner, the activity and then the stopping of the transient state circuits of each of the devices, and means (20) for combining the outputs of the various devices.

9. Device according to Claim 8, **characterized in that** the combination means implement, on the outputs of the various devices, a combination of EXCLUSIVE OR type.

10. Device according to Claim 9, **characterized in that** the controlling means include at least one counter (21) which receives at its input the output signal of means which combine the outputs of the various devices, and means for controlling the activity or the stopping of the means (of the type with semiconductor(s)) of the said devices as a function of the counting down of the said counter.

11. Device according to one of the preceding claims, **characterized in that** it is integrated in a specific integrated circuit or a programmable integrated circuit.

## Patentansprüche

1. Vorrichtung zur Erzeugung eines Zufallssignals, **dadurch gekennzeichnet, dass** sie eine elektronische Schaltung mit Übergangsstadium sowie Mittel (112), die den Betrieb und/oder das Abschalten der Schaltung steuern können, aufweist, um ein Zufallssignal an deren Ausgang zu erzeugen.

2. Vorrichtung nach Anspruch 1, **dadurch gekennzeichnet, dass** die Schaltung logische Mittel vom Typ Halbleiter aufweist.

3. Vorrichtung nach Anspruch 2, **dadurch gekennzeichnet, dass** sie einen Oszillatorkreis mit Mitteln vom Typ Halbleiter und Mittel, die den Betrieb und/oder das Abschalten der Schaltung steuern können, aufweist.

4. Vorrichtung nach Anspruch 3, **dadurch gekennzeichnet, dass** der Ausgang des Oszillatorkreises (11) an dessen Eingang zurückgekoppelt ist (113).

5. Vorrichtung nach Anspruch 4, **dadurch gekennzeichnet, dass** der Oszillatorkreis einen Umschalter (111) bildende Mittel, die an seinem Ausgang (111 a) das an seinem Eingang (111 b) vorhandene Signal invertieren, sowie eine Schleife zwischen seinem Eingang und Ausgang aufweist.

6. Vorrichtung nach Anspruch 5, **dadurch gekennzeichnet, dass** Mittel, die den Betrieb und/oder das Abschalten der Schaltung steuern können, Schalter bildende Mittel (112) aufweisen, die in der Schleife zwischen dem Ausgang der einen Umschalter bildenden Mittel und dem Ausgang des Oszillatorkreises angeordnet sind.

7. Vorrichtung nach einem der Ansprüche 5 oder 6, **dadurch gekennzeichnet, dass** die Umschalter bildenden Mittel eine Vielzahl von Umschaltern (111) in ungerader Zahl aufweisen.

8. Vorrichtung mit logischer Schaltung/logischen Schaltungen zur Erzeugung eines Zufallssignals, **dadurch gekennzeichnet, dass** sie zur kontinuierlichen Erzeugung des Zufallssignals mehrere Vorrichtungen (11a, 11 b) nach einem der vorhergehenden Ansprüche, Mittel (21, 22), um nacheinander abwechselnd den Betrieb und dann das Abschalten der Schaltungen mit Übergangsstadium jedes der Vorrichtungen zu steuern, sowie Mittel (20), um die Ausgänge der verschiedenen Vorrichtungen zu kombinieren, aufweist.

9. Vorrichtung nach Anspruch 8, **dadurch gekennzeichnet, dass** die Kombinationsmittel an den Ausgängen der verschiedenen Vorrichtungen eine Kombination vom Typ EXKLUSIVES ODER verwenden.

10. Vorrichtung nach Anspruch 9, **dadurch gekennzeichnet, dass** die Steuermittel mindestens einen Zähler (21), der am Eingang das Ausgangssignal von Mitteln, die die Ausgänge der verschiedenen Vorrichtungen kombinieren, empfängt, sowie Mittel zum Steuern des Betriebs und/oder des Abschaltens der Mittel vom Typ Halbleiter der Vorrichtungen in Abhängigkeit der Abwärtszählung des Zählers aufweist.

11. Vorrichtung nach einem der vorhergehenden Ansprüche, **dadurch gekennzeichnet, dass** sie in einer spezifischen oder programmierbaren integrierten Schaltung integriert ist.
